# EUROPÄISCHE PATENTANMELDUNG

(11) **EP 4 852 674 A1**
(43) Veröffentlichungstag der Anmeldung: **09.12.2026**
(21) Anmeldenummer: 25181116.2
(22) Anmeldetag: 05.06.2025
(51) Int. Cl.: H10K 30/85, H10K 30/81, H10K 30/40

(54) **DÜNNSCHICHTSOLARZELLE, HERSTELLUNGSVERFAHREN UND SOLARMODUL**

(71) Anmelder: Forschungszentrum Jülich GmbH, 52428 Jülich (DE)
(72) Erfinder: DU, Tian, 90429 Nürnberg (DE); DAG, Hakan, 91052 Erlangen (DE); BRABEC, Christoph, 4040 Linz (AT)
(74) Vertreter: Gille Hrabal Partnerschaftsgesellschaft mbB Patentanwälte

(57) **Zusammenfassung**

Die Erfindung betrifft eine Dünnschichtsolarzelle, ein Verfahren zu deren Herstellung sowie ein Solarmodul. Eine Dünnschichtsolarzelle (1) umfasst einen Elektronenleiter (6) und eine Kohlenstoff oder Gold enthaltende Kathode. Zwischen der Kathode und dem Elektronenleiter (6) befindet sich eine Zwischenschicht (7), die einen n-dotierten Halbleiter umfasst. Dies überwindet die energetische Diskrepanz zwischen der Kathode und dem Elektronenleiter.

## Beschreibung

Die Erfindung betrifft eine Dünnschichtsolarzelle, ein Verfahren zu deren Herstellung sowie ein Solarmodul.

Dünnschichtsolarzellen umfassen eine dünne Schicht eines Halbleitermaterials, die insbesondere auf ein Substrat wie Glas oder Kunststoff aufgebracht ist. Im Vergleich zu Solarzellen aus kristallinem Silizium sind Dünnschichtsolarzellen weniger material- und energieintensiv in der Herstellung.

Perowskit-Solarzellen können beispielsweise ein transparentes, leitendes Oxid, eine Extraktionsschicht für Elektronen mit blockierender Wirkung für Löcher (Elektronenleiter), eine Perowskit-Schicht als Absorbermaterial, eine Extraktionsschicht für Löcher mit blockierender Wirkung für Elektronen (Lochleiter) und eine Metallschicht als Rückkontakt umfassen, z. B. Silber, Gold oder Kupfer. Perowskit-Solarzellen können deutlich dünner als Siliziumzellen gebaut werden und sind im Gegensatz zu Siliziumzellen in der Lage, auch grünes und blaues Licht gut zu verwerten.

Die Herstellung von Perowskit-Solarzellen ist allerdings aufwändig. Elektroden werden aufgedampft, was teuer ist und eine Skalierung zu größeren Stückzahlen erschwert. Zudem sind konventionelle Elektrodenmaterialien teuer. Um dies zu beheben, wurden Kohlenstoffelektroden entwickelt, die aus günstigem, gut verfügbaren und chemisch stabilen Kohlenstoff hergestellt sind und zudem gedruckt werden können. Kohlenstoffelektroden können das Gold ersetzen und als Anode dienen, also als Kontakt am Lochleiter.

Zudem sind invertierte Perowskit-Solarzellen bekannt. Eine invertierte Perowskit-Solarzelle hat, anders als die herkömmliche Konfiguration einer Perowskit-Solarzelle, eine Lochtransportschicht, die sich oberhalb der Perowskit-Schicht befindet und/oder eine Elektronensammlerschicht, der sich oberhalb der Perowskit-Schicht befindet. Statt n-i-p ist die Schichtfolge also p-i-n. Es kann ein organischer n-Typ-Kontakt anstelle eines Metalloxids verwendet werden. Invertierte Perowskit-Solarzellen zeigen gegenüber klassischen Perowskit-Solarzellen eine reduzierte Strom-Spannungs-Hysterese und ggf. eine erhöhte Stabilität.

Die Metallelektrode oder Metallkathode umfasst typischerweise Silber, Kupfer und/oder Aluminium. Typischerweise werden Metalle mit niedriger Austrittsarbeit verwendet, sodass Elektronen leicht herausgelöst werden können. Das metallische Elektrodenmaterial kann jedoch unter Betriebsbedingungen diffundieren und/oder reagieren. Beispielsweise migriert Silber und reagiert mit Halogenidionen. Dies führt zu Leistungsverlusten.

In einer Perowskit-Solarzelle können sich photogenerierte Ladungsträger in unterschiedliche Richtungen bewegen. Löcher bewegen sich durch die Lochtransportschicht, z. B. abwärts, zur Anode und Elektronen bewegen sich durch die Elektronentransportschicht, z. B. aufwärts, zur Kathode.

Die oben genannten Definitionen, Merkmale und Eigenschaften können beliebig mit den im Folgenden beschriebenen Aspekten und Ausgestaltungen der Erfindung kombiniert werden, sofern nichts Gegenteiliges angegeben ist.

Allerdings ist es in invertierten Perowskit-Solarzellen nicht möglich, eine Kohlenstoff enthaltende Elektrode zu verwenden. Hierbei müsste Kohlenstoff als Kathode dienen, was aufgrund der großen energetischen Diskrepanz (engl: "energetic mismatch") zwischen Kohlenstoff und dem Elektronenleiter nicht möglich ist.

Es ist die Aufgabe der Erfindung, eine weiterentwickelte Dünnschichtsolarzelle, ein zugehöriges Herstellungsverfahren und ein Solarmodul zur Verfügung zu stellen. Insbesondere soll die Verwendung einer Kohlenstoff enthaltenden Kathode ermöglicht werden.

Die Aufgabe wird gelöst durch die Dünnschichtsolarzelle gemäß Anspruch 1 sowie das Herstellungsverfahren und das Solarmodul gemäß den nebengeordneten Ansprüchen. Vorteilhafte Ausgestaltungen sind in den Unteransprüchen angegeben.

Zur Lösung der Aufgabe dient eine Dünnschichtsolarzelle, umfassend einen Elektronenleiter und eine Kohlenstoff oder Gold enthaltende Kathode. Zwischen der Kathode und dem Elektronenleiter befindet sich eine Zwischenschicht, die bevorzugt einen insbesondere n-dotierten Halbleiter umfasst.

Es hat sich gezeigt, dass eine Zwischenschicht mit einem n-dotierten Halbleiter geeignet ist, die energetische Diskrepanz zwischen Kohlenstoff bzw. Gold und dem Elektronenleiter zu verringern bzw. aufzuheben. Dies ermöglicht die Verwendung eines Kohlenstoff oder Gold enthaltenden Materials als Kathode einer Dünnschichtsolarzelle.

Die Erfinder haben erkannt, dass die energetische Diskrepanz durch eine zu hohe Austrittsarbeit des Kohlenstoffs bzw. Goldes bedingt ist. Kohlenstoff verhält sich chemisch inert, ähnlich wie Au oder Pt. Es kann deshalb kein ohmscher Kontakt zwischen dem Kohlenstoff bzw. Gold und dem Elektronenleiter hergestellt werden. Es konnte gezeigt werden, dass dies durch die Zwischenschicht geändert werden kann.

Gold ist ebenso geeignet wie Kohlenstoff. Aufgrund der günstigen Verfügbarkeit wird Kohlenstoff bevorzugt. Im Folgenden wird demnach stets von Kohlenstoff gesprochen, obwohl stets Gold mitgemeint ist. Alles für die Kohlenstoff enthaltende Kathode Gesagte gilt analog für die Gold enthaltende Kathode.

Ein Elektronenleiter dient dem Leiten von Elektronen. Insbesondere wird die Leitung von Löchern dagegen blockiert. Der Elektronenleiter wird auch als Elektronentransportschicht (engl: "Electron Transport Layer" ETL) bezeichnet. Beispielsweise ist der Elektronenleiter ein organischer Elektronenleiter.

Eine Zwischenschicht ist eine Schicht, die zwischen etwas liegt. Hier liegt die Zwischenschicht zwischen der Kathode und dem Elektronenleiter. Die Zwischenschicht kann direkt an die Kathode und/oder den Elektronenleiter anliegen. Alternativ oder ergänzend kann eine oder können mehrere andere Schichten zwischen der Zwischenschicht und der Kathode und/oder zwischen der Zwischenschicht und dem Elektronenleiter vorhanden sein.

Die Zwischenschicht enthält einen n-dotierten Halbleiter oder besteht daraus. Bei der n-Dotierung werden Elektronendonatoren implantiert, also Fremdatome, die als Elektronendonatoren wirken. Insbesondere hat die Zwischenschicht ein gutes n-Typ-Dotierungsniveau, d. h. eine minimale Ladungsträgerkonzentration. Insbesondere enthält die Zwischenschicht einen stark n-dotierten Halbleiter. Beispielsweise ist die Zwischenschicht geeignet, eine Verschiebung des Vakuumniveaus an der Grenzfläche zu erzeugen, die die energetische Diskrepanz (Fehlanpassung) zwischen Kohlenstoff und Elektronenleiter minimiert.

Insbesondere umfasst die Zwischenschicht ein Material, welches Dipoleigenschaften aufweist, oder ist daraus hergestellt. Insbesondere erzeugt die Zwischenschicht ein Dipol an der Grenzfläche (engl.: "Interfacial Dipole"). Dies kann durch die n-Dotierung ermöglicht werden.

Die Kathode enthält Kohlenstoff und/oder dient der elektrischen Kontaktierung der Solarzelle auf Seite des Lochleiters. Insbesondere ist die Kathode aus Kohlenstoff hergestellt oder besteht aus Kohlenstoff.

Insbesondere beträgt der Füllfaktor mindestens 65%, bevorzugt mindestens 70%. Es hat sich gezeigt, dass mit der erfindungsgemäßen Zwischenschicht in Verbindung mit der Kohlenstoff oder Gold enthaltende Kathode ein derart hoher Füllfaktor erreichen lässt.

Wird Gold oder Kohlenstoff ohne geeignete Zwischenschicht als Kathode verwendet, tritt im Falle von Gold in der Leerlaufspannung ein Verlust von mindestens 100 oder 150 mV auf, bei Kohlenstoff sind es mehrere 100 bis über 500 mV. Dies wird durch den Einsatz einer erfindungsgemäßen, dotierten Zwischenschicht verhindert. Der Verlust ist demnach insbesondere < 100 mV, bevorzugt < 50 mV oder noch kleiner.

Es können unterschiedliche Dünnschichtsolarzellen verwendet werden, beispielsweise organische Dünnschichtsolarzellen (OPV), Grätzelzellen (Farbstoffsolarzellen, engl.: "dye-sensitized solar cell", DSSC), anorganische Dünnschichtsolarzellen, insbesondere umfassend Cadmiumtellurid (CdTe), Kupfer-Zink-Zinn-Sulfid/Selenid (CZTS oder CZTSe), amorphes Silizium (a-Si), Antimonselenid-Solarzellen (SbSe), Kupfer-Indium-Gallium-Diselenid-Solarzellen, Kupfer-Indium-Disulfid-Solarzellen (CIGS), und/oder Silber-Indium-Disulfid-Solarzellen (AglnS).

In einer Ausgestaltung ist die Dünnschichtsolarzelle eine invertierte Perowskit-Solarzelle. Die damit einhergehenden Vorteile und Merkmale wurden bereits oben beschrieben, worauf hier Bezug genommen wird.

In einer Ausgestaltung umfasst die Solarzelle ferner Perowskit, einen Lochleiter und/oder eine Anode.

Eine Perowskit-Solarzelle umfasst Perowskit, insbesondere mindestens einen Perowskit-Kristall. Ein Perowskit im Sinne der Erfindung ist ein kristallines Material mit einer Perowskit-Struktur, auch allgemein als ABX₃-Struktur bezeichnet, beispielsweise CaTiO₃. In einer Perowskit-Solarzelle können insbesondere organisch-anorganische Halogenid-Perowskite verwendet werden. Diese können als A-Kation Methylammonium (MA), Formamidinium (FA) und/oder Caesium (Cs) enthalten, als B Kation Blei (Pb), Zinn (Sn), Bismutdioxid, Germanium, Kupfer, Mangan, Eisen, Kobalt und/oder Nickel enthalten und/oder als X Anion die Halogene Chlor (CI), Brom (Br) und/oder lod (I) enthalten.

Der Lochleiter wird auch als Lochtransportschicht (engl: "Hole Transport Layer" HTL) bezeichnet. Der Lochleiter dient dem Leiten von Löchern. Insbesondere wird die Leitung von Elektronen dagegen blockiert.

Die Anode dient der elektrischen Kontaktierung auf der Anodenseite.

In einer Ausgestaltung umfasst die Zwischenschicht ein Metalloxid. Metalloxide sind aufgrund ihrer vergleichsweise geringen Austrittsarbeit geeignete Zwischenschichten für die erfindungsgemäße Solarzelle. Es hat sich zudem gezeigt, dass Metalloxide mechanisch besonders robust sind. Auf diese Weise wird es möglich, die Kohlenstoff enthaltende Kathode durch ein Druckverfahren herzustellen. Dabei auftretende mechanische Belastungen haben keinen nachteiligen Einfluss auf die Zwischenschicht. Auch chemisch sind Metalloxide stabil gegenüber den Bedingungen beim Druck der Kathode.

Beispiele für geeignete Metalloxide sind Titandioxid, z. B. TiO₂, und Zinkoxid, z. B. ZnO. Insbesondere wird ein dotiertes Metalloxid verwendet. Es kann mit Fluor dotiertes Zinnoxid (FTO) verwendet werden. Es kann Zinkoxid verwendet werden, welches mit Aluminium (AZO), Gallium (GZO) oder Indium (IZO) dotiert ist. Andere Dotierstoffe, die bevorzugt die n-Typ-Dotierung erhöhen, sind ebenfalls möglich.

In einer Ausgestaltung umfasst die Zwischenschicht Zinnoxid, insbesondere SnOₓ. Typischerweise gilt: x ≤ 1,5 und/oder x ≥ 2,0. x ist insbesondere kleiner als 2,0. In einigen Ausführungsformen gilt: x ≤ 1,7. Die Zwischenschicht kann eine SnO₂-Struktur aufweisen, weist aber typischerweise Sauerstofffehlstellen auf. Deshalb liegt insgesamt typischerweise ein nicht-stöchiometrisches Verhältnis von Sn und O vor, also ein unterstöchiometrischer Sauerstoffanteil.

Zinnoxid ist ein Halbleiter und zeigt besonders gute elektronenleitende Eigenschaften. Zwischen Zinnoxid und Perowskit finden keine schädlichen Reaktionen statt.

In einer Ausgestaltung weist die Zwischenschicht eine Dicke von mindestens 10 nm, insbesondere mindestens 15 nm und/oder höchstens 30 nm, insbesondere höchstens 25 nm auf.

Bei einer zu geringen Dicke ist die Zwischenschicht keine ausreichende mechanisch Stabilität auf. Es kann dann der direkte Kontakt zwischen dem Elektronenleiter und der Kathode nicht ausreichend blockiert werden, so dass Kohlenstoff zum Elektronenleiter gelangen kann. In der Folge bleibt die energetische Diskrepanz zumindest anteilig bestehen.

Bei einer zu großen Dicke steigt der Widerstand für die Elektronenleitung. In diesem Fall verringert sich die Effizienz der Solarzelle.

Dem Fachmann sind geeignete Messverfahren wohlbekannt, mit denen Schichtdicken in dem beanspruchten Bereich gemessen werden können.

Die genannten Dicken haben sich als Optimum zwischen diesen Extremen herausgestellt. Insbesondere ist die Dicke an der dünnsten Stelle nicht geringer als 10 nm oder 15 nm und/oder die Dicke an der dicksten Stelle ist nicht größer als 25 nm oder 30 nm.

Ein weiterer Aspekt der Erfindung ist ein Verfahren zur Herstellung einer Dünnschichtsolarzelle, insbesondere einer invertierten Perowskit-Solarzelle. Das Verfahren umfasst Auftragen eines Materials, welches einen Halbleiter umfasst, zur Herstellung einer Zwischenschicht.

Das Material kann zum Beispiel auf einen Elektronenleiter aufgetragen werden.

Nach dem Auftragen ist eine Schicht, die den Halbleiter umfasst oder ausbildet, hergestellt. Es kann sich dabei um die Zwischenschicht handeln. Es können zur Herstellung der Zwischenschicht auch noch ein oder mehrere weitere Schritte erfolgen, wie weiter unten ausgeführt wird.

Der Halbleiter kann dotiert oder undotiert sein. Eine Dotierung kann in einem nachfolgenden Schritt erzeugt werden.

Grundsätzlich spielt es für die Eignung der Zwischenschicht mit dem Halbleiter keine Rolle, mit welchem Verfahren die Zwischenschicht aufgetragen wird. Demnach sind grundsätzlich verschiedene Verfahren geeignet.

In einer Ausgestaltung wird das Material durch Atomlagenabscheidung aufgetragen. Atomlagenabscheidung (engl.: "Atomic Layer Deposition", ALD) ist ein Dünnfilmabscheideverfahren, bei dem auf einem Ausgangsmaterial eine dünne Schicht aus der Gasphase abgeschieden wird. Unterschiedliche Präkursoren, die zyklisch abwechselnd zugeführt werden, reagieren chemisch zu einem abzuscheidenden Stoff.

Auf diese Weise können sehr dünne Schichten bis hin zu Monolagen abgeschieden werden.

Atomlagenabscheidung hat den Vorteil, dass eine besonders robuste bzw. mechanisch widerstandsfähige Schicht erzeugt wird.

In einer Ausgestaltung ist das Material Zinnoxid. Zinnoxid hat sich als besonders vorteilhaft erwiesen. In Verbindung mit Atomlagenabscheidung hat Zinnoxid den weiteren Vorteil, dass es bei vergleichsweise niedrigen Temperaturen abgeschieden werden kann.

In einer weiteren Ausgestaltung wird nach dem Auftragen des Materials eine thermische Nachbehandlung durchgeführt.

Eine thermische Nachbehandlung meint eine definierte, vorübergehende Erhöhung der Temperatur, um ein bestimmtes Ziel zu erreichen. Insbesondere soll eine n-Dotierung des Halbleiters erreicht werden. Die thermische Nachbehandlung erfolgt nach dem Auftragen des Materials der Zwischenschicht. Beispielsweise wird eine Atmosphäre, in der sich die hergestellte Struktur befindet, erwärmt, beispielsweise in einem Ofen.

Die thermische Nachbehandlung kann der Steigerung der mechanischen Widerstandsfähigkeit der Zwischenschicht dienen. Alternativ oder ergänzend kann die thermische Nachbehandlung die Anzahl von Sauerstofffehlstellen erhöhen und damit die Austrittsarbeit verringern. Dazu können Sauerstoffatome aus dem aufgetragenen Material entfernt werden. Die thermische Nachbehandlung kann somit die n-Dotierung verursachen oder verstärken. Auf diese Weise kann die Effizienz der Solarzelle signifikant erhöht werden.

Insbesondere ist die Zwischenschicht nach der thermischen Nachbehandlung fertiggestellt.

In einer Ausgestaltung erfolgt die thermische Nachbehandlung in einer zumindest im Wesentlichen sauerstofffreien Atmosphäre.

Insbesondere erfolgt die thermische Nachbehandlung in einer zumindest im Wesentlichen inerten und/oder zumindest im Wesentlichen sauerstofffreien Atmosphäre. Im Wesentlichen meint, dass keine signifikanten Mengen an Sauerstoff vorhanden sind. So kann die Anzahl an Sauerstofffehlstellen besonders effektiv erhöht werden. Dem Fachmann ist bekannt, dass eine absolute Sauerstofffreiheit weder notwendig noch praktikabel ist. Die Atmosphäre kann beispielsweise Stickstoff umfassen oder aus Stickstoff bestehen.

In einer weiteren Ausgestaltung erfolgt die thermische Nachbehandlung bei einer Temperatur von mindestens 100 °C und/oder höchstens 200 °C.

Insbesondere erfolgt die thermisch Nachbehandlung bei einer Temperatur von mindestens 80 °C, bevorzugt mindestens 100 °C oder mindestens 120 °C, besonders bevorzugt mindestens 140 °C und/oder höchstens 220 °C, bevorzugt höchstens 200 °C oder höchstens 180 °C, besonders bevorzugt höchstens 160 °C oder 150 °C. Es hat sich herausgestellt, dass diese Temperaturen zweckdienlich sind. Diese Temperaturen lassen sich zudem mit geringem technischen Aufwand erzeugen.

In einer weiteren Ausgestaltung umfasst das Verfahren ferner ein Auftragen eines Kohlenstoff enthaltenden Materials durch ein Druckverfahren, insbesondere durch Schablonendruck, insbesondere zwecks Herstellung der Kohlenstoff enthaltenden Kathode.

Ein Kohlenstoff enthaltendes Material, z. B. Kohlenstoff, wird durch ein Druckverfahren aufgetragen. Es kann sich um eine Paste handeln. Insbesondere wird das Material auf die Zwischenschicht aufgetragen. Das Material kann so gewählt sein, dass eine Kohlenstoffkathode hergestellt werden kann.

In einer Ausführungsform erfolgt anschließend eine zweite thermische Nachbehandlung zum Verfestigen bzw. Aushärten des gedruckten Materials. "Zweite" dient hierbei lediglich der begrifflichen Abgrenzung von der oben beschriebenen thermischen Nachbehandlung nach dem Auftragen des Materials. Die thermischen Nachbehandlungen sind unabhängig voneinander. Es kann nur eine der beiden thermischen Nachbehandlungen erfolgen oder beide.

In einer weiteren Ausführungsform wird überschüssiges Material mit einer Rakel entfernt. So kann besonders zweckmäßig eine Kathode hergestellt werden.

In einer Ausgestaltung wird das Material mit dem n-dotierten Halbleiter auf eine Schichtfolge aufgetragen wird, die zumindest die folgenden Schichten umfasst: optional Glas, optional Anode, Lochleiter, Perowskit, Elektronenleiter.

Insbesondere umfasst die Schichtfolge alle genannten Schichten und/oder die angegebene Reihenfolge der Schichten.

Die Anode kann ein transparentes, leitendes Oxid umfassen oder daraus hergestellt sein (engl.: "Transparent Conducting Oxide", TCO), beispielsweise Indium-dotiertes Zinnoxid (ITO) oder Fluor-dotiertes Zinnoxid (FTO). Die Anode kann auf Glas vorliegen. Das Glas kann als Substrat bzw. Superstrat dienen.

Der Lochleiter kann NiOₓ und/oder Me-4Pacz umfassen oder daraus hergestellt sein.

Der Elektronenleiter kann C60 umfassen oder daraus hergestellt sein. Es können jedoch alternativ oder ergänzend beliebige andere Elektronenleiter verwendet werden. Beispielsweise können Fullerene, Fullerenderivate und/oder Metalloxidnanopartikel verwendet werden. Die Zwischenschicht kann auf den Elektronenleiter aufgetragen werden.

Nach der Herstellung der Solarzelle kann eine Strom-Spannungs-Kennlinie der Solarzelle gemessen werden.

Ein weiterer Aspekt der Erfindung ist ein Solarmodul, umfassend mindestens eine erfindungsgemäße Solarzelle und/oder mindestens eine mit dem erfindungsgemäßen Verfahren hergestellte Solarzelle. Das Solarmodul kann eine Vielzahl derartiger Solarzellen umfassen.

Nachfolgend werden Ausführungsbeispiele der Erfindung auch anhand von Figuren näher erläutert. Merkmale der Ausführungsbeispiele können einzeln oder in einer Mehrzahl mit den beanspruchten Gegenständen kombiniert werden, sofern nichts Gegenteiliges angegeben ist. Die beanspruchten Schutzbereiche sind nicht auf die Ausführungsbeispiele beschränkt.

Es zeigen:
- Figuren 1 und 2:: den schematischen Aufbau einer invertierten Perowskit-Solarzelle,
- Figur 3:: Schritte eines Herstellungsverfahrens,
- Figuren 4 und 5:: eine schematische Darstellung der Energieniveau-Ausrichtung, sowie
- Figuren 6 und 7:: eine schematische Darstellung des Einflusses der n-Dotierung.

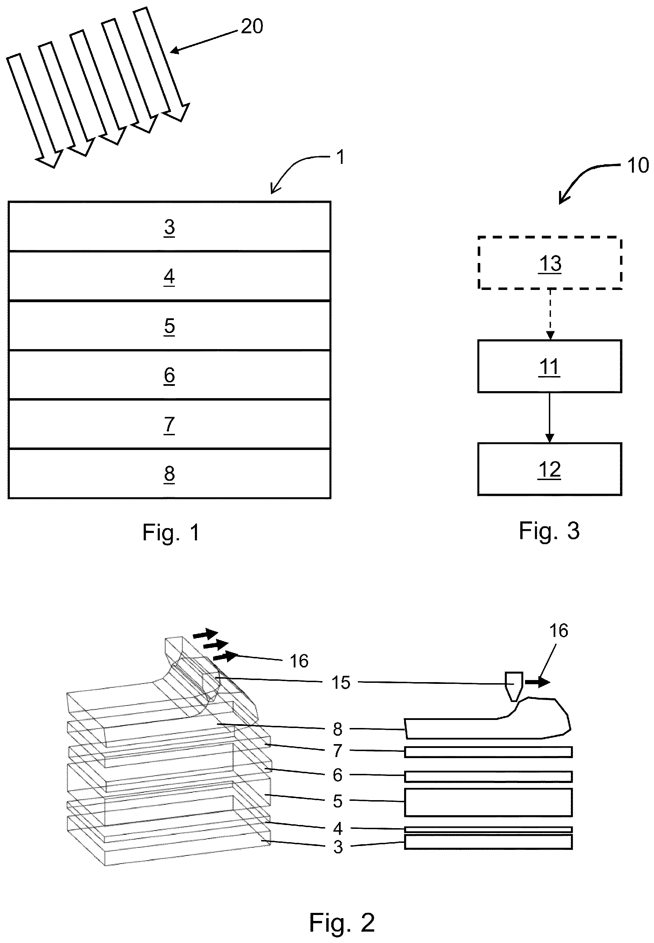

Figur 1 zeigt rein schematisch den Aufbau einer Dünnschichtsolarzelle 1 am Beispiel einer invertierten Perowskit-Solarzelle 1. Die gezeigten Schichtdicken sind nicht maßstabsgetreu. An der dem einstrahlenden Licht 20 zugewandte Seite befindet sich die Anode 3, darunter ein Lochleiter 4, das Perowskit 5, der Elektronenleiter 6, die Zwischenschicht 7 und die Kathode 8. Oberhalb der Anode kann eine Schutzschicht angeordnet sein, etwa aus Glas.

Das Perowskit 5 dient als Absorber. Es nimmt Sonnenlicht auf. Dabei werden Elektronen aus dem Halbleiter herausgelöst und es werden einerseits freie Ladungsträger und andererseits Löcher erzeugt. Die Löcher werden durch den Lochleiter 4 zur Anode 3 transportiert. Die Elektronen werden durch den Elektronenleiter 6 und die Zwischenschicht 7 zur Kathode 8 transportiert. Die elektrische Kontaktierung erfolgt an der Anode 3 und der Kathode 8. Auf diese Weise wird eine Ausgangsspannung erzeugt.

Erfindungsgemäß enthält die Kathode 8 Kohlenstoff oder besteht aus Kohlenstoff. Um die energetische Diskrepanz zwischen dem Elektronenleiter 6 und dem Kohlenstoff der Kathode 8 zu überwinden, wird eine Zwischenschicht 7 mit einem n-dotierten Halbleiter eingefügt.

Figur 2 zeigt eine ähnliche Darstellung der Solarzelle 10, und zwar während der Herstellung. Aus diesem Grund ist die Solarzelle um 180° gedreht dargestellt. Auf der linken Seite ist eine perspektivische Darstellung gezeigt und auf der rechten Seite eine Schnittzeichnung.

Die Abfolge der Schichten entspricht der Figur 1, sodass auf die obige Beschreibung verwiesen wird und auf Wiederholungen verzichtet wird. Es ist zudem ein Druckverfahren zum Auftragen der Kohlenstoff enthaltenden Kathode 8 auf die Zwischenschicht 7 dargestellt. Zu diesem Zweck ist eine Rakel 15 vorhanden, die sich entlang der Pfeile 16 bewegt. Dabei wird Kohlenstoff enthaltendes Material, insbesondere eine Paste, in einer gewünschten Schichtdicke aufgetragen. Überschüssiges Material wird mittels der Rakel 15 abgestreift.

Figur 3 zeigt schematisch Schritte eines Verfahrens 10 zur Herstellung einer Solarzelle. Das Verfahren 10 umfasst optional das Herstellen 13 einer Schicht oder Schichtfolge, beispielsweise eines Teils der Schichtfolge aus Figur 1 oder 2. Die Schichtfolge kann den Elektronenleiter, ggf. das Perowskit, ggf. den Lochleiter und ggf. die Anode umfassen. Das Verfahren umfasst ferner das Auftragen 11 eines Materials, welches einen Halbleiter umfasst, zur Herstellung der Zwischenschicht. Das Verfahren 10 umfasst ferner die eine Nachbehandlung 12, insbesondere eine thermische Nachbehandlung 12, bei der eine n-Dotierung des Halbleiters erzeugt wird. So kann eine erfindungsgemäße Solarzelle hergestellt werden.

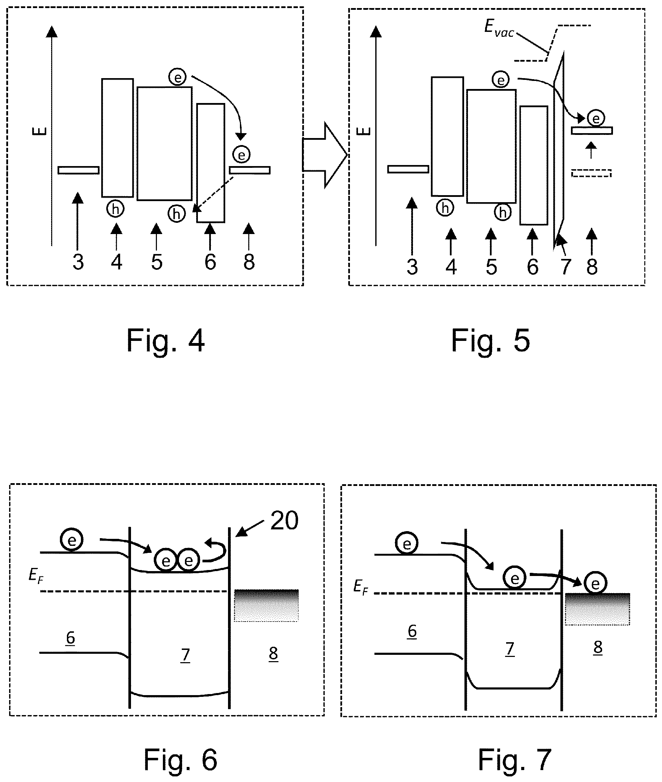

Die Figuren 4 und 5 zeigen schematisch die Leitungsband-Energie der einzelnen Schichten der Solarzelle und den Einfluss der Zwischenschicht mit n-dotiertem Halbleiter auf die Leitungsband-Energie. Dargestellt ist die Energie E über die einzelnen Schichten Anode 3, Lochleiter 4, Perowskit 5, Elektronenleiter 6, Kohlenstoff enthaltende Kathode 8 und im Falle der Figur 5 zudem der Zwischenschicht 7. Es zeigt sich, dass die Sauerstofffehlstellenbildungsenergie E_{vac} im Bereich der Zwischenschicht 7 deutlich ansteigt. Dies ist ohne Zwischenschicht 7 nicht möglich, wie in Figur 4 dargestellt, wo das Elektron nicht zur Kathode gelangen kann, sondern mit dem Loch rekombiniert. Deshalb ist die Zwischenschicht 7 geeignet, die Polarität des Kohlenstoffs von einer Anode zum Sammeln von Löchern hin zu einer Kathode zum Sammeln von Elektronen zu invertieren. Die Zwischenschicht 7 ist dabei bevorzugt abgestimmt auf das Material des Elektronenleiters 6, z. B. C60, hat also eine zu diesem passende Leitungsbandenergie.

Die Figuren 6 und 7 zeigen schematisch die Bandprofile an der Grenzfläche zwischen Elektronenleiter 6, Zwischenschicht 7 und Kohlenstoff oder Gold enthaltender Kathode 8. Zudem ist das Fermi-Niveau E_{F} der Kathode 8, insbesondere von Kohlenstoff oder Gold, eingezeichnet. In Figur 6, die nicht erfindungsgemäß ausgestaltet ist, ist als Zwischenschicht 7 undotiertes SnO₂ vorhanden, während in der erfindungsgemäßen Figur 7 n-dotiertes SnO₂₋ₓ vorliegt. Es zeigt sich, dass ohne die Dotierung eine Extraktionsbarriere 21 für Elektronen e vorliegt, die verhindert, dass Elektronen e vom Elektronenleiter 6 über die Zwischenschicht 7 zur Kathode 8 gelangen. Dies ist bei dotierten SnO2₋ₓ nicht der Fall. Elektronen e gelangen über die Zwischenschicht 7 zur Kathode 8

Undotiertes SnO₂ bildet keinen ohmschen Kontakt mit Kohlenstoff oder Gold, sondern einen Schottky-Kontakt. Der Schottky-Kontakt behindert die Elektronenextraktion und führt zu einer Elektronenakkumulation an den Grenzflächen. Mit einem insbesondere stark n-dotierten SnO₂₋ₓ kann dies gelöst werden: Die Bandverbiegung wird sowohl an der Grenzfläche zwischen Elektronenleiter 6 und Zwischenschicht 7 als auch an der Grenzfläche zwischen Zwischenschicht 7 und Kathode 8 größer. Das Fermi-Niveau E_{F} von Kohlenstoff oder Gold befindet sich nahe an dem Leitungsband von SnO₂₋ₓ. Der verengte Raumladungsbereich ermöglicht das Tunneln von Elektronen durch die Schottky-Barriere, was zu einem quasi-ohmschen Kontakt zwischen SnO₂₋ₓ und Kohlenstoff oder Gold führt. Es hat sich gezeigt, dass in allen Fällen die Fermi-Niveaus E_{F} der Elektroden mit denen des Elektronenleiters übereinstimmen, so dass das eingebaute Potenzial der Solarzellen unabhängig von den Variationen der Austrittsenergie des SnOₓ und/oder der Elektroden unverändert bleibt. Zusammenfassend lässt sich sagen, dass zur Erreichung der umgekehrten Polarität von Kohlenstoff oder Gold für die Funktion der Kathode in Dünnschichtsolarzelleneine ausreichende Verschiebung des Vakuumniveaus nach oben für die Ausrichtung der Fermi-Niveaus und/oder eine Minimierung der Breite der Raumladungsschicht möglich ist, die ein effizientes Tunneln der Elektronen ermöglicht.

### Bezugszeichenliste

| | |
|---|---|
| Solarzelle | 1 |
| Anode | 3 |
| Lochleiter | 4 |
| Perowskit | 5 |
| Elektronenleiter | 6 |
| Zwischenschicht | 7 |
| Kathode | 8 |
| Verfahren | 10 |
| Auftragen | 11 |
| Nachbehandlung | 12 |
| Herstellen | 13 |
| Rakel | 15 |
| Bewegung | 16 |
| Licht | 20 |
| Extraktionsbarriere | 21 |
| Elektron | e |
| Loch | h |
| Energie | E |
| Sauerstofffehlstellenbildungsenergie | E_{vac} |
| Fermi-Niveau | E_{F} |

## Patentansprüche

1. Dünnschichtsolarzelle (1), umfassend einen Elektronenleiter (6) und eine Kohlenstoff oder Gold enthaltende Kathode (8), wobei sich zwischen dem Elektronenleiter (6) und der Kathode (8) eine Zwischenschicht (7) befindet, die einen n-dotierten Halbleiter umfasst.

2. Dünnschichtsolarzelle (1) nach dem vorhergehenden Anspruch, wobei die Dünnschichtsolarzelle eine invertierte Perowskit-Solarzelle ist.

3. Dünnschichtsolarzelle (1) nach einem der vorhergehenden Ansprüche h, ferner umfassend Perowskit (5), einen Lochleiter (4) und/oder eine Anode (3).

4. Dünnschichtsolarzelle (1) nach einem der vorhergehenden Ansprüche, wobei die Zwischenschicht (7) ein Metalloxid umfasst.

5. Dünnschichtsolarzelle (1) nach einem der vorhergehenden Ansprüche, Dünnschichtsolarzelle die Zwischenschicht (7) Zinnoxid umfasst.

6. Dünnschichtsolarzelle (1) nach einem der vorhergehenden Ansprüche, wobei die Zwischenschicht (7) eine Dicke von mindestens 10 nm, insbesondere mindestens 15 nm und/oder höchstens 30 nm, insbesondere höchstens 25 nm aufweist.

7. Verfahren (10) zur Herstellung einer Dünnschichtsolarzelle, insbesondere einer invertierten Perowskit-Solarzelle (1), umfassend Auftragen (11) eines Materials, welches einen Halbleiter umfasst, zur Herstellung einer Zwischenschicht (7).

8. Verfahren (10) nach dem vorhergehenden Anspruch, wobei das Material durch Atomlagenabscheidung aufgetragen wird.

9. Verfahren (10) nach einem der zwei vorhergehenden Ansprüche, wobei das Material Zinnoxid ist.

10. Verfahren (10) nach einem der drei vorhergehenden Ansprüche, wobei nach dem Auftragen (11) des Materials eine thermische Nachbehandlung (12) durchgeführt wird.

11. Verfahren (10) nach dem vorhergehenden Anspruch, wobei die thermische Nachbehandlung (12) in einer zumindest im Wesentlichen sauerstofffreien Atmosphäre erfolgt.

12. Verfahren (10) nach einem der zwei vorhergehenden Ansprüche, wobei die thermische Nachbehandlung (12) bei einer Temperatur von mindestens 100 °C und/oder höchstens 200 °C erfolgt.

13. Verfahren (10) nach einem der sechs vorhergehenden Ansprüche, ferner umfassend Auftragen eines Kohlenstoff oder Gold enthaltenden Materials durch ein Druckverfahren, insbesondere Schablonendruck, zwecks Herstellung der Kohlenstoff oder Gold enthaltenden Kathode (8).

14. Verfahren (10) nach dem vorhergehenden Anspruch, wobei überschüssiges Material mit einer Rakel entfernt wird.

15. Verfahren (10) nach einem der acht vorhergehenden Ansprüche, wobei das Material mit dem n-dotierten Halbleiter auf eine Schichtfolge aufgetragen wird, die zumindest die folgenden Schichten umfasst: optional Glas, optional Anode (3), Lochleiter (4), Perowskit (5), Elektronenleiter (6).

16. Solarmodul, umfassend mindestens eine Solarzelle (1) nach einem der Ansprüche 1 bis 6 und/oder mindestens eine mit dem Verfahren (10) nach einem der Ansprüche 7 bis 15 hergestellte Solarzelle (1).
